# EUROPEAN PATENT SPECIFICATION

(11) **EP 3 208 514 B1**
(45) Date of publication and mention of the grant of the patent: **31.01.2018**
(21) Application number: 16191507.9
(22) Date of filing: 29.09.2016
(51) Int. Cl.: F21K 9/232, H01L 33/64, H01L 33/62, F21Y 115/10

(54) **LIGHT BULB USING LED FILAMENT**
GLÜHLAMPE MIT LED-LEUCHTDRAHT
AMPOULE ÉLECTRIQUE UTILISANT UN FILAMENT DE DEL

(30) Priority: 22.02.2016 GB 201603000
(43) Date of publication of application: 23.08.2017
(73) Proprietor: BGT Materials Limited, Manchester M13 9PL (GB)
(72) Inventor: LAI, CHUNG-PING, 302 ZHUBEI CITY (TW)
(74) Representative: Brown, Michael Stanley

(56) References cited:
- CN-A- 104 406 068
- CN-A- 104 989 981
- CN-U- 203 848 212
- US-A1- 2014 375 201

## Description

### FIELD OF THE INVENTION

The present invention relates to a light-emitting diode filament lamp which improves heat dissipation and radiation.

### BACKGROUND OF THE INVENTION

A conventional light-emitting diode filament lamp contains at least one light-emitting diode (led) filament with transparent substrate, such as glass substrate or sapphire substrate, wherein a plurality of light-emitting diode (led) dies are adhered on one surface of the transparent substrate, and the at least one light-emitting diode (led) filament are made by using a fluorescent glue and in a wire bonding process.

In addition, a filament support is made of glass and is configured to support the at least one light-emitting diode (led) filament, but its heat conductivity is insufficient.

Prior art documents US 2014/375201 A1 and CN 104 406 068 A disclose typical light-emitting diode filament lamps.

Prior art documents CN 104 989 981 A and CN 203 848 212 U disclose the use of graphene in light-emitting diode bulb lamps. The present invention has arisen to mitigate and/or obviate the afore-described disadvantages.

### SUMMARY OF THE INVENTION

The primary objective of the present invention is to provide a light-emitting diode filament lamp which improves heat dissipation and radiation.

To obtain above-mentioned objective, a light-emitting diode filament lamp provided by the present invention contains: a lamp cap, a transparent housing, at least one filament support, and at least one light-emitting diode (led) filament.

The lamp cap is electrically connected with an external power supply so as to supply power to the at least one led filament, the transparent housing being hollow and including an opening.

Each filament support includes a first metal post electrically connected with a positive terminal and includes a second metal post electrically connected with a negative terminal so as to transmit driving power.

Each led filament includes a first electrode pin electrically connected with the first metal post and includes a second electrode pin electrically connected with the second metal post, such that a led drive circuit is defined.

Any one of graphene, borazon (bn) and thermally conductive ceramic powders is coated on each of the first metal post and the second metal post so as to form a black body radiation layer, the at least one led filament and the at least one filament support are housed in the transparent housing, and the opening is closed by the lamp cap.

Preferably, the first metal post and the second post of said each filament support are straight or arcuate.

Preferably, the light-emitting diode filament lamp comprises two filament supports, and a first metal post and a second metal post of each of the two filament supports are electrically connected with a positive terminal and a negative terminal of a lamp cap, respectively.

Preferably, a plurality of led filaments are electrically connected with the first metal post and the second post of said each filament support in a parallel connecting manner.

Preferably, a plurality of led filaments are electrically connected with the first metal post and the second metal post of said each filament support in a series connecting manner.

Preferably, said each led filament is any one of rigid led filament, flexible led filament, and combination of the rigid and flexible led filaments.

Preferably, the flexible led filament contains a metal substrate, a plurality of light-emitting diode (led) dies fixed on a first surface of the metal substrate, the first electrode pin, and the second electrode pin, wherein the plurality of led dies, the first electrode pin, and the second electrode pin are secured on the first surface of the metal substrate by using die adhesive with graphene or hexagonal boron nitride (hBN), wherein the plurality of led dies are electrically connected with the first electrode pin and the second electrode pin in a series connecting manner by way of a metal wire, a fluorescent glue packages the plurality of led dies on the metal substrate, and parts the first electrode pin and the second electrode pin expose outside the fluorescent glue, the metal substrate contains a black body radiation layer coated on a second surface thereof and having graphene or hexagonal boron nitride (hBN).

Preferably, said each led filament is straight or is bent.

Preferably, the lamp cap includes a power controller electrically connected therewith configured to convert electric energy from the external power supply into driving power for driving the at least one led filament.

### BRIEF DESCRIPTION OF THE DRAWINGS

FIG. 1 is a schematic view showing the assembly of a light-emitting diode filament lamp according to a preferred embodiment of the present invention.
FIG. 2 is a schematic view showing the assembly of a part of a light-emitting diode filament lamp according to another preferred embodiment of the present invention.
FIG. 3 is a schematic view showing the assembly of a part of a light-emitting diode filament lamp according to another preferred embodiment of the present invention.
FIG. 4 is a schematic view showing the assembly of a part of a light-emitting diode filament lamp according to another preferred embodiment of the present invention.
FIG. 5 is a schematic view showing the assembly of a part of a light-emitting diode filament lamp according to another preferred embodiment of the present invention.
FIG. 6 is a cross sectional view of FIG. 5.
FIG. 7 is another cross sectional view of FIG. 5.
FIG. 8 is a schematic view showing the assembly of a part of a light-emitting diode filament lamp according to another preferred embodiment of the present invention.
FIG. 9 is a schematic view showing the assembly of a part of a light-emitting diode filament lamp according to another preferred embodiment of the present invention.

### DETAILED DESCRIPTION OF THE PREFERRED EMBODIMENTS

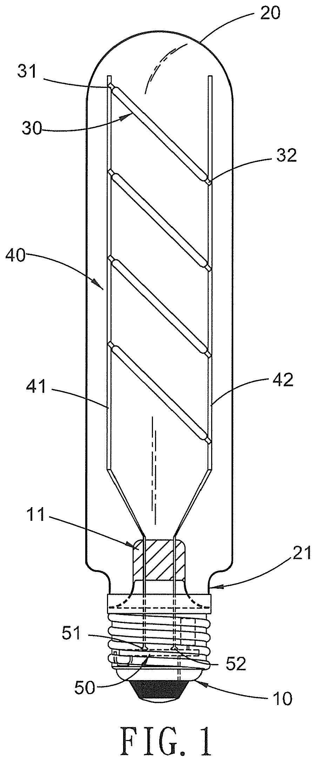

With reference to FIG. 1, a light-emitting diode filament lamp according to a preferred embodiment of the present invention comprises: a lamp cap 10, a transparent housing 20, at least one filament support 40, and at least one light-emitting diode (led) filament 30.

The lamp cap 10 is electrically connected with an external power supply so as to supply power to the at least one led filament 30. The lamp cap 10 is any one of Edison screw (as shown in FIG. 1 and designate as E22, E26, and E27), bi-pin connector (designated as GU10), and bayonet cap (designated as B22). The at least one led filament 30 is driven by the external power supply to emit lights, and the external power supply supplies DC power, for example, the lamp cap 10 is mounted on a lamp holder for supplying the DC power. In another embodiment, the lamp cap 10 converts AC power of the external power supply into the DC power. Referring to FIG. 1, the lamp cap 10 includes a power controller 50 electrically connected therewith, and the power controller 50 is a light-emitting diode (led) drive circuit, an input end of which is electrically connected with the DC power, and an output end of the led drive circuit has a positive terminal 51 and a negative terminal 52 which output the DC power, such that the power controller 50 converts electric energy from the external power supply into driving power for driving the at least one led filament 30.

The transparent housing 20 is hollow and includes an opening 21, and the transparent housing 20 is made of glass. The at least one led filament 30 and the at least one filament support 40 are housed in the transparent housing 20, and gases (such as nitrogen or noble gases) are filled into the transparent housing 20, thereafter the opening 21 is closed by the lamp cap 10.

Each filament support 40 includes a first metal post 41 electrically connected with the positive terminal 51 and includes a second metal post 42 electrically connected with the negative terminal 52 so as to transmit the driving power. The lamp cap 10 has a glass seat 11 on which the first metal post 41 and the second metal post 42 are mounted, and the first metal post 41 inserts through the glass seat 11 so as to electrically connect with the positive terminal 51 of the power controller 50, the second metal post 42 inserts through the glass seat 11 so as to electrically connect with the negative terminal 52 of the power controller 50.

Each led filament 30 includes a first electrode pin 31 electrically connected with the first metal post 41 and includes a second electrode pin 32 electrically connected with the second metal post 42, such that the led drive circuit is defined. The first electrode pin 31 and the second electrode pin 32 of said each led filament 30 are soldered on a first surface of the first metal post 41 and a first surface of the second metal post 42 respectively so that the first metal post 41 and the second metal post 42 transmit the DC power to the at least one led filament 30, thus emitting the lights from the at least one led filament 30.

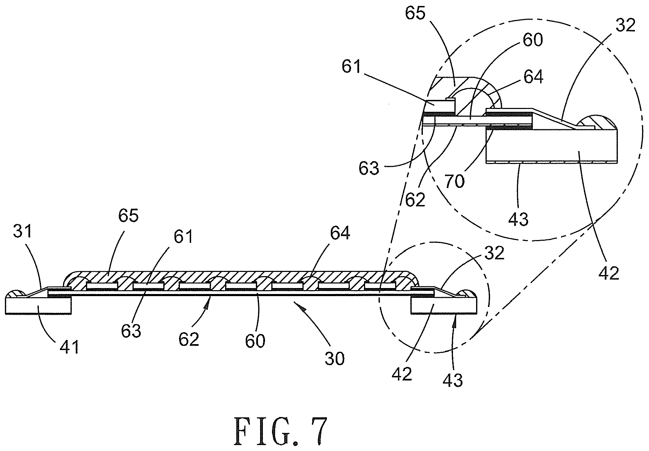

In another embodiment, as illustrated in FIG. 7, any one of graphene, borazon (bn) and thermally conductive ceramic powders is coated on each of the first metal post 41 and the second metal post 42 so as to form a black body radiation layer 43. Preferably, the black body radiation layer 43 is coated on a second surface of the first metal post 41 and a second surface of the second metal post 42, such that when a part of heat transmits to the first metal post 41 and the second metal post 42 from said each led filament 30 via the first electrode pin 31 and the second electrode pin 32, thermal conductivity and thermal radiation area of the first metal post 41 and the second metal post 42 increase by using the graphene, the borazon (bn) or the thermally conductive ceramic powders of the black body radiation layer 43. In addition, heat exchange of the first metal post 41, the second metal post 42, and the gases in the transparent housing 20 enhances greatly so as to improve heat dissipation and radiation.

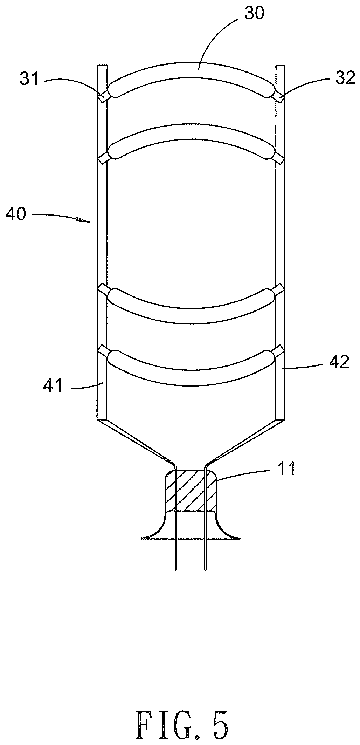

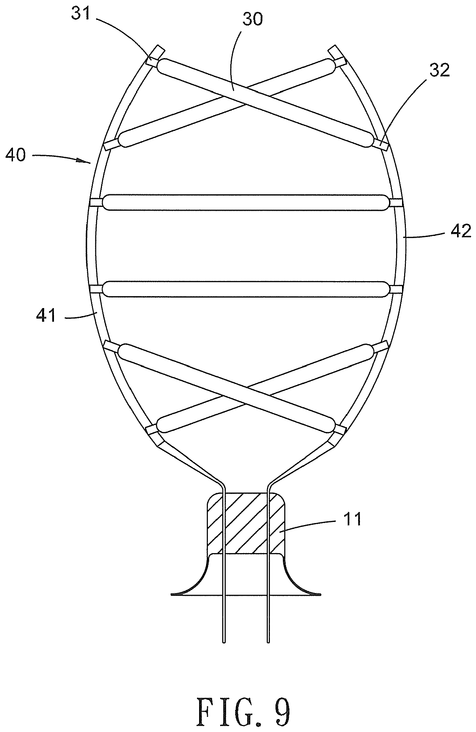

Said each led filament 30 is any one of rigid led filament, flexible led filament, and combination of the rigid and flexible led filaments, wherein the rigid led filament is straight and is not bent, i.e., the rigid led filament is made of glass substrate or sapphire substrate. As shown in FIG. 5, said each led filament 30 is the flexible led filament and is bent in an arc shape. As illustrated in FIG. 9, said each led filament 30 is the combination of the rigid and flexible led filaments.

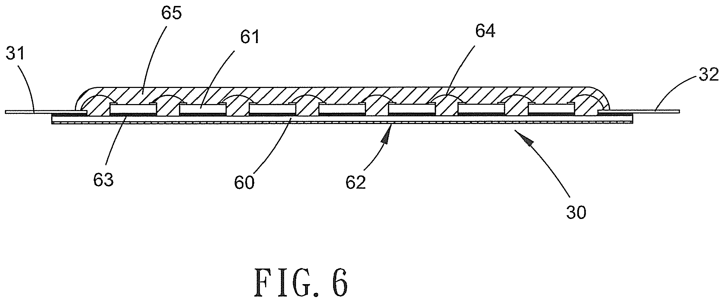

Referring to FIG. 6, the flexible led filament contains a metal substrate 60, a plurality of light-emitting diode (led) dies 61 fixed on a first surface of the metal substrate 60, a first electrode pin 31, and a second electrode pin 32, wherein the plurality of led dies 61, the first electrode pin 31, and the second electrode pin 32 are secured on the first surface of the metal substrate 60 by using die adhesive 63 with graphene or hexagonal boron nitride (hBN), wherein the plurality of led dies 61 are electrically connected with the first electrode pin 31 and the second electrode pin 32 in a series connecting manner by way of a metal wire 64, and the metal wire 64 is made in a wire bonding process. A fluorescent glue 65 packages the plurality of led dies 61 on the metal substrate 60, and parts the first electrode pin 31 and the second electrode pin 32 expose outside the fluorescent glue 65. The metal substrate 60 contains a black body radiation layer 62 coated on a second surface thereof and having any one of graphene, hexagonal boron nitride (hBN), and thermally conductive ceramic powders. With reference to FIG. 7, the metal substrate 60 is mounted on the first metal post 41 and the second metal post 42 by means of electrical insulating glue 70 so as to avoid short circuit between the first metal post 41 and the second metal post 42.

Referring to FIG. 1, a plurality of led filaments 30 are electrically connected with the first metal post 41 and the second metal post 42 of a filament support 40 in a parallel connecting manner.

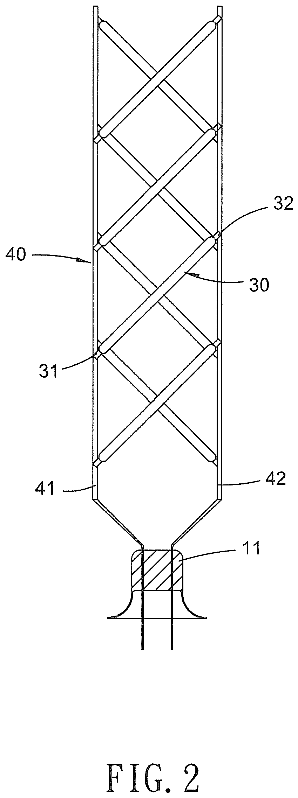

As shown in FIG. 2, a plurality of led filaments 30 are electrically connected with the first metal post 41 and the second metal post 42 of a filament support 40 in a parallel connecting manner and are intersected together so as to enhance lux of the light-emitting diode filament lamp.

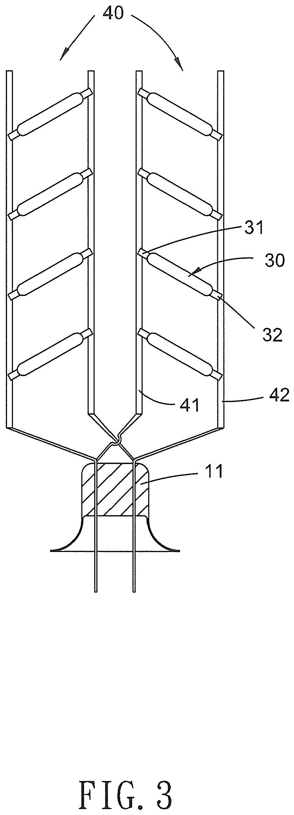

As illustrated in FIG. 3, the light-emitting diode filament lamp comprises two filament supports 40, 40a, wherein a first metal post 41 and a second metal post 42 of each of the two filament supports 40, 40a are electrically connected with a positive terminal 51 and a negative terminal 52 of a lamp cap 10, respectively.

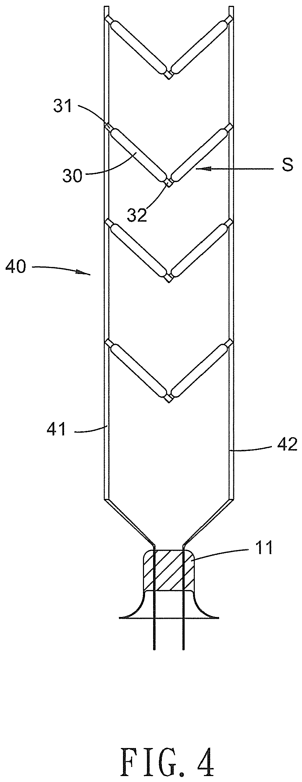

Referring to FIG. 4, a plurality of filament sets S are electrically connected with a first metal post 41 and a second metal post 42 of a filament support 40, wherein each filament set S has two led filaments 30 which are serially connected together.

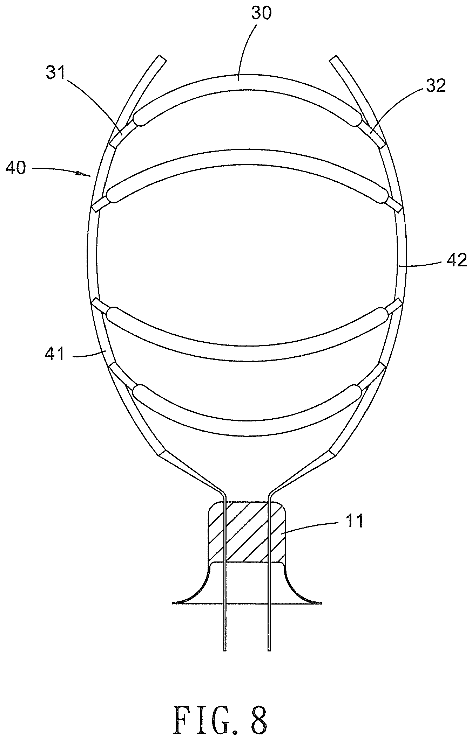

Preferably, the first metal post 41 and the second post 42 of said each filament support 40 are straight or arcuate. As shown in FIGS. 8 and 9, the first metal post 41 and the second metal post 42 are arcuate.

While the preferred embodiments of the invention have been set forth for the purpose of disclosure, modifications of the disclosed embodiments of the invention as well as other embodiments thereof may occur to those skilled in the art. Accordingly, the appended claims are intended to cover all embodiments which do not depart from the scope of the invention.

## Claims

1. A light-emitting diode filament lamp comprising:
a lamp cap (10), a transparent housing (20), at least one filament support (40), and at least one light-emitting diode (led) filament (30);
the lamp cap (10) being electrically connected with an external power supply so as to supply power to the at least one led filament (30), the transparent housing (20) being hollow and including an opening (21);
wherein each filament support (40) includes a first metal post (41) electrically connected with a positive terminal (51) and includes a second metal post (42) electrically connected with a negative terminal (52) so as to transmit driving power; and each led filament (30) includes a first electrode pin (31) electrically connected with the first metal post (41) and includes a second electrode pin (32) electrically connected with the second metal post (42), such that a led drive circuit is defined **characterised in that** any one of graphene, borazon (bn) and thermally conductive ceramic powders is coated on each of the first metal post (41) and the second metal post (42) so as to form a black body radiation layer (43), the at least one led filament (30) and the at least one filament support (40) are housed in the transparent housing (20), and the opening (21) is closed by the lamp cap (10).

2. The light-emitting diode filament lamp as claimed in claim 1, wherein the first metal post (41) and the second metal post (42) of said each filament support (40) are straight or arcuate.

3. The light-emitting diode filament lamp as claimed in claim 1, wherein the light-emitting diode filament lamp comprises two filament supports (40), (40a), and a first metal post (41) and a second metal post (42) of each of the two filament supports (40), (40a) are electrically connected with a positive terminal (51) and a negative terminal (52) of the lamp cap (10), respectively.

4. The light-emitting diode filament lamp as claimed in claim 1, wherein a plurality of led filaments (30) are electrically connected with the first metal post (41) and the second metal post (42) of said each filament support (40) in a parallel connecting manner.

5. The light-emitting diode filament lamp as claimed in claim 1, wherein a plurality of led filaments (30) are electrically connected with the first metal post (41) and the second metal post (42) of said each filament support (40) in a series connecting manner.

6. The light-emitting diode filament lamp as claimed in claim 1, wherein said each led filament (30) is any one of rigid led filament, flexible led filament, and combination of the rigid and flexible led filaments.

7. The light-emitting diode filament lamp as claimed in claim 6, wherein the flexible led filament contains a metal substrate (60), a plurality of light-emitting diode (led) dies (61) fixed on a first surface of the metal substrate (60), the first electrode pin (31), and the second electrode pin (32), wherein the plurality of led dies (61), the first electrode pin (31), and the second electrode pin (32) are secured on the first surface of the metal substrate (60) by using die adhesive (63) with graphene or hexagonal boron nitride (hBN), wherein the plurality of led dies (61) are electrically connected with the first electrode pin (31) and the second electrode pin (32) in a series connecting manner by way of a metal wire (64), a fluorescent glue (65) packages the plurality of led dies (61) on the metal substrate (60), and parts the first electrode pin (31) and the second electrode pin (32) expose outside the fluorescent glue (65), the metal substrate (60) contains a black body radiation layer (62) coated on a second surface thereof and having graphene or hexagonal boron nitride (hBN).

8. The light-emitting diode filament lamp as claimed in claim 1, wherein said each led filament (30) is straight or is bent.

9. The light-emitting diode filament lamp as claimed in claim 1, wherein the lamp cap (10) includes a power controller (50) electrically connected therewith configured to convert electric energy from the external power supply into driving power for driving the at least one led filament (30).

## Patentansprüche

1. Leuchtdioden-Leuchtdrahtlampe, die Folgendes umfasst:
einen Lampensockel (10), ein transparentes Gehäuse (20), mindestens einen Leuchtdrahthalter (40) und mindestens einen Leuchtdioden(LED)-Leuchtdraht (30);
wobei der Lampensockel (10) elektrisch mit einer externen Leistungsversorgung verbunden ist, um dem mindestens einen LED-Leuchtdraht (30) Leistung zuzuführen, wobei das transparente Gehäuse (20) hohl ist und eine Öffnung (21) aufweist;
wobei jeder Leuchtdrahthalter (40) einen ersten Metallstab (41) aufweist, der elektrisch mit einem positiven Anschluss (51) verbunden ist, und einen zweiten Metallstab (42) aufweist, der elektrisch mit einem negativen Anschluss (52) verbunden ist, um eine Ansteuerungsleistung zu übertragen; und
wobei jeder LED-Leuchtdraht (30) einen ersten Elektrodenstift (31) aufweist, der elektrisch mit dem ersten Metallstab (41) verbunden ist, und einen zweiten Elektrodenstift (32) aufweist, der elektrisch mit dem zweiten Metallstab (42) verbunden ist, so dass eine LED-Ansteuerungsschaltung gebildet ist,
**dadurch gekennzeichnet, dass**
eines von Graphen-, Borazon- (bn) und thermisch leitfähigem Keramikpulver durch Beschichtung auf jeden des ersten Metallstabs (41) und des zweiten Metallstabs (42) aufgebracht ist, um eine Schwarzkörper-Strahlungsschicht (43) zu bilden, wobei der mindestens eine LED-Leuchtdraht (30) und der mindestens eine Leuchtdrahthalter (40) in dem transparenten Gehäuse (20) aufgenommen sind und die Öffnung (21) von dem Lampensockel (10) verschlossen ist.

2. Leuchtdioden-Leuchtdrahtlampe nach Anspruch 1, wobei der erste Metallstab (41) und der zweite Metallstab (42) jedes Leuchtdrahthalters (40) gerade oder gebogen sind.

3. Leuchtdioden-Leuchtdrahtlampe nach Anspruch 1, wobei die Leuchtdioden-Leuchtdrahtlampe zwei Leuchtdrahthalter (40), (40a) umfasst und ein erster Metallstab (41) und ein zweiter Metallstab (42) jedes der zwei Leuchtdrahthalter (40), (40a) jeweils elektrisch mit einem positiven Anschluss (51) und einem negativen Anschluss (52) des Lampensockels (10) verbunden sind.

4. Leuchtdioden-Leuchtdrahtlampe nach Anspruch 1, wobei eine Vielzahl von LED-Leuchtdrähten (30) elektrisch mit dem ersten Metallstab (41) und dem zweiten Metallstab (42) jedes Leuchtdrahthalters (40) in der Art einer Parallelschaltung verbunden sind.

5. Leuchtdioden-Leuchtdrahtlampe nach Anspruch 1, wobei eine Vielzahl von LED-Leuchtdrähten (30) elektrisch mit dem ersten Metallstab (41) und dem zweiten Metallstab (42) jedes Leuchtdrahthalters (40) in der Art einer Reihenschaltung verbunden sind.

6. Leuchtdioden-Leuchtdrahtlampe nach Anspruch 1, wobei jeder LED-Leuchtdraht (30) einer eines starren LED-Leuchtdrahts, eines flexiblen LED-Leuchtdrahts und einer Kombination aus einem starren und einem flexiblen LED-Leuchtdraht ist.

7. Leuchtdioden-Leuchtdrahtlampe nach Anspruch 6, wobei der flexible LED-Leuchtdraht ein Metallsubstrat (60), eine Vielzahl von Leuchtdioden(LED)-Dies (61), die auf einer ersten Fläche des Metallsubstrats (60) befestigt sind, den ersten Elektrodenstift (31) und den zweiten Elektrodenstift (32) enthält, wobei die Vielzahl von LED-Dies (61), der erste Elektrodenstift (31) und der zweite Elektrodenstift (32) unter Verwendung eines Die-Haftvermittlers (63) mit Graphen oder hexagonalem Bornitrid (hBN) auf der ersten Fläche des Metallsubstrats (60) gesichert sind, wobei die Vielzahl von LED-Dies (61) über einen Metalldraht (64) elektrisch mit dem ersten Elektrodenstift (31) und dem zweiten Elektrodenstift (32) in der Art einer Reihenschaltung verbunden ist, ein fluoreszierender Kleber (65) die Vielzahl von LED-Dies (61) auf dem Metallsubstrat (60) packt und bei Teilen des ersten Elektrodenstifts (31) und des zweiten Elektrodenstifts (32) der fluoreszierende Kleber (65) nach außen freiliegt, das Metallsubstrat (60) eine Schwarzkörper-Strahlungsschicht (62) enthält, die durch Beschichtung auf eine zweite Fläche desselben aufgebracht ist und Graphen oder hexagonales Bornitrid (hBN) aufweist.

8. Leuchtdioden-Leuchtdrahtlampe nach Anspruch 1, wobei jeder LED-Leuchtdraht (30) gerade ist oder gekrümmt ist.

9. Leuchtdioden-Leuchtdrahtlampe nach Anspruch 1, wobei der Lampensockel (10) einen Leistungscontroller (50) aufweist, der elektrisch mit diesem verbunden ist und so ausgeführt ist, dass er elektrische Energie aus der externen Leistungsversorgung in eine Ansteuerungsleistung zum Ansteuern des mindestens einen LED-Leuchtdrahts (30) umwandelt.

## Revendications

1. Lampe à filament de diode électroluminescente comprenant :
un culot de lampe (10), une enveloppe transparente (20), au moins un support de filament (40), et au moins un filament de diode électroluminescente (DEL) (30) ;
le culot de lampe (10) étant relié électriquement à une alimentation électrique externe de manière à délivrer de l'énergie à l'au moins un filament de DEL (30), l'enveloppe transparente (20) étant creuse et comportant une ouverture (21) ;
dans laquelle chaque support de filament (40) comporte un premier montant métallique (41) relié électriquement à une borne positive (51) et comporte un deuxième montant métallique (42) relié électriquement à une borne négative (52) de manière à transmettre de l'énergie d'excitation ; et
chaque filament de DEL (30) comporte une première broche d'électrode (31) reliée électriquement au premier montant métallique (41) et comporte une deuxième broche d'électrode (32) reliée électriquement au deuxième montant métallique (42), de telle sorte qu'un circuit d'excitation de DEL est défini ;
**caractérisée en ce que**
du graphène, du borazon (bn) ou des poudres céramiques thermoconductrices sont indifféremment déposés à la fois sur le premier montant métallique (41) et le deuxième montant métallique (42) de manière à former une couche à rayonnement de corps noir (43), l'au moins un filament de DEL (30) et l'au moins un support de filament (40) sont logés dans l'enveloppe transparente (20), et l'ouverture (21) est fermée par le culot de lampe (10).

2. Lampe à filament de diode électroluminescente selon la revendication 1, dans laquelle le premier montant métallique (41) et le deuxième montant métallique (42) de chaque dit support de filament (40) sont droits ou arqués.

3. Lampe à filament de diode électroluminescente selon la revendication 1, la lampe à filament de diode électroluminescente comprenant deux supports de filament (40), (40a), et un premier montant métallique (41) et un deuxième montant métallique (42) de chacun des deux supports de filament (40), (40a) étant reliés électriquement à une borne positive (51) et une borne négative (52) du culot de lampe (10), respectivement.

4. Lampe à filament de diode électroluminescente selon la revendication 1, dans laquelle une pluralité de filaments de DEL (30) sont reliés électriquement au premier montant métallique (41) et au deuxième montant métallique (42) de chaque dit support de filament (40) à la manière d'un branchement en parallèle.

5. Lampe à filament de diode électroluminescente selon la revendication 1, dans laquelle une pluralité de filaments de DEL (30) sont reliés électriquement au premier montant métallique (41) et au deuxième montant métallique (42) de chaque dit support de filament (40) à la manière d'un branchement en série.

6. Lampe à filament de diode électroluminescente selon la revendication 1, dans laquelle chaque dit filament de DEL (30) est indifféremment un filament de DEL rigide, un filament de DEL souple ou une combinaison des filaments de DEL rigide et souple.

7. Lampe à filament de diode électroluminescente selon la revendication 6, dans laquelle le filament de DEL souple contient un substrat métallique (60), une pluralité de puces de diode électroluminescente (DEL) (61) fixées sur une première surface du substrat métallique (60), la première broche d'électrode (31) et la deuxième broche d'électrode (32), dans laquelle la pluralité de puces de DEL (61), la première broche d'électrode (31) et la deuxième broche d'électrode (32) sont fixées sur la première surface du substrat métallique (60) au moyen d'un adhésif pour puce (63) avec du graphène ou du nitrure de bore hexagonal (hBN), dans laquelle la pluralité de puces de DEL (61) sont reliées électriquement à la première broche d'électrode (31) et la deuxième broche d'électrode (32) à la manière d'un branchement en série au moyen d'un fil métallique (64), une colle fluorescente (65) encapsule la pluralité de puces de DEL (61) sur le substrat métallique (60), et des parties de la première broche d'électrode (31) et de la deuxième broche d'électrode (32) exposent à l'extérieur la colle fluorescente (65), le substrat métallique (60) contient une couche à rayonnement de corps noir (62) déposée sur une deuxième surface de celui-ci et ayant du graphène ou du nitrure de bore hexagonal (hBN).

8. Lampe à filament de diode électroluminescente selon la revendication 1, dans laquelle chaque filament de DEL (30) est droit ou est courbé.

9. Lampe à filament de diode électroluminescente selon la revendication 1, dans laquelle le culot de lampe (10) comporte un contrôleur de puissance (50) relié électriquement à celui-ci configuré pour transformer l'énergie électrique provenant de l'alimentation électrique externe en énergie d'excitation pour exciter l'au moins un filament de DEL (30) .
